# EUROPEAN PATENT APPLICATION

(11) **EP 4 383 980 A1**
(43) Date of publication of application: **12.06.2024**
(21) Application number: 23208780.9
(22) Date of filing: 09.11.2023
(51) Int. Cl.: H10B 41/27, H10B 41/40, H10B 43/27, H10B 43/40

(54) **SEMICONDUCTOR MEMORY DEVICE**

(30) Priority: 29.11.2022 KR 20220162368
(71) Applicant: Samsung Electronics Co., Ltd., Suwon-si, Gyeonggi-do 16677 (KR)
(72) Inventor: PARK, Minji, 16677 Suwon-si, Gyeonggi-do (KR); SHIN, Dongha, 16677 Suwon-si, Gyeonggi-do (KR); JEON, Hongsoo, 16677 Suwon-si, Gyeonggi-do (KR)
(74) Representative: Kuhnen & Wacker Patent- und Rechtsanwaltsbüro PartG mbB

(57) **Abstract**

Disclosed are semiconductor memory devices comprising a peripheral region (100) including a substrate (110), high voltage transistors (112a) on the substrate (110), first lower lines (122) connected to the high voltage transistors (112a), and second lower lines (124) connected to the first lower lines (122), and a cell region (200) on the peripheral region (100). The first and the second lower lines (124) extend along a first direction (DR1) parallel to an upper surface of the substrate (110). The first lower lines (122) include first high voltage lines (122a) and first low voltage lines. The second lower lines (124) include second high voltage lines (124a) and second low voltage lines (124b). The second high voltage lines (124a) and the first low voltage lines (124b) are separated in a second direction (DR2) parallel to the upper surface of the substrate (110) and a third direction (DR3) perpendicular to the upper surface of the substrate (110), and the second low voltage lines (124b) and the first high voltage lines (122a) are separated in the second direction (DR2) and the third direction (DR3).

## Description

### BACKGROUND

Example embodiments of the present disclosure described herein relate to semiconductor memory devices, and more particularly, relate to semiconductor memory devices that reduce reliability deterioration due to coupling between a high voltage wire and a low voltage wire.

A semiconductor memory device may be mainly classified as a volatile memory or a non-volatile memory. Read and write speeds of the volatile memory (e.g., a DRAM or an SRAM) are fast, but the data stored in the volatile memory disappear when a power is turned off. In contrast, the non-volatile memory may retain data even when the power is turned off.

A representative example of the non-volatile memory is a flash memory. The flash memory may store multi-bit data of two or more bits in one memory cell. The flash memory that stores the multi-bit data may have one erase state and a plurality of program states depending on threshold voltage distributions.

Recently, as information communication devices become multi-functional, the semiconductor memory device is required to have higher capacity and higher integration. The semiconductor memory device may include page buffers for storing data in memory cells or outputting data from the memory cells. And the page buffers may have semiconductor devices such as transistors.

The size of a semiconductor device included in the page buffer may be reduced due to a demand for a chip size reduction according to an increase in the degree of integration of memory devices and the development of process technology. Accordingly, the size of a region in which wires connected to semiconductor devices are arranged may also be reduced.

### SUMMARY

Example embodiments of the present disclosure provide semiconductor memory devices that reduce reliability of a semiconductor device from being deteriorated as electrical coupling occurs between a high voltage wire and a low voltage wire.

According to some example embodiments, a semiconductor memory device comprises a peripheral region including a lower substrate, high voltage transistors on the lower substrate, a first lower lines electrically connected to the high voltage transistors, and second lower lines electrically connected to the first lower lines on the first lower lines, and a cell region on the peripheral region.

The first lower lines and the second lower lines extend along a first direction parallel to an upper surface of the lower substrate. The first lower lines include first high voltage lines and first low voltage lines. The second lower lines include second high voltage lines and second low voltage lines. The second high voltage lines and the first low voltage lines being separated in a second direction parallel to the upper surface of the lower substrate and a third direction perpendicular to the upper surface of the lower substrate, and the second low voltage lines and the first high voltage lines being separated in the second direction and the third direction.

According to some example embodiments, A semiconductor memory device comprises a lower substrate, high voltage transistors on the lower substrate, first high voltage lines electrically connected to a high voltage source/drain region of the high voltage transistors, second high voltage lines electrically connected to the first high voltage lines on the first high voltage lines, first low voltage lines electrically connected to a low voltage source/drain region of the high voltage transistors, second low voltage lines electrically connected to the first low voltage lines on the first low voltage lines, a cell array on the second low voltage lines and including a gate stack and vertical channels penetrating the gate stack along a vertical direction, and bit lines electrically connected to the vertical channels and the second high voltage lines.

The first high voltage lines, the second high voltage lines, the first low voltage lines, the second low voltage lines, and the bit lines extend along a first direction parallel to an upper surface of the lower substrate.

### BRIEF DESCRIPTION OF THE FIGURES

The above and other objects and features of the present disclosure will become apparent by describing in detail embodiments thereof with reference to the accompanying drawings.
FIG. 1 is a cross-sectional view of a semiconductor memory device according to the present disclosure.
FIG. 2 is a diagram illustrating some example embodiments of peripheral circuit line of FIG. 1.
FIG. 3 is a diagram illustrating first lower lines, second lower lines, first lower contacts, second lower contacts, and third lower contacts of FIG. 2.
FIG. 4 is a cross-sectional view taken along the line A-A' of FIG. 2.
FIG. 5 is a diagram illustrating some example embodiments of peripheral circuit line of FIG. 1.
FIG. 6 is a cross-sectional view taken along line B-B' of FIG. 5.
FIG. 7 is a diagram illustrating some example embodiments of peripheral circuit line of FIG. 1.
FIG. 8 is a cross-sectional view taken along line C-C' of FIG. 7.
FIG. 9 is a diagram illustrating some example embodiments of peripheral circuit line of FIG. 1.
FIG. 10 is a cross-sectional view taken along line D-D' of FIG. 9.
FIG. 11 is a block diagram illustrating a storage device including the semiconductor memory device illustrated in FIG. 1.
FIG. 12 is a block diagram illustrating the flash memory illustrated in FIG. 11 according to some example embodiments.
FIG. 13 is a circuit diagram illustrating some example embodiments of a memory block BLK1 of the memory cell array illustrated in FIG. 12.
FIG. 14 is a circuit diagram illustrating cell strings selected by first string selection line SSL1 from among cell strings of the memory block BLK1 illustrated in FIG. 1 3.
FIG. 15 is a circuit diagram illustrating some example embodiments of the first page buffer PB1 illustrated in FIG. 12.
FIG. 16 is a view illustrating a memory device according to some example embodiments of the present disclosure.

### DETAILED DESCRIPTION

Below, example embodiments of the present disclosure will be described in detail and clearly to such an extent that an ordinary one in the art easily implements the invention.

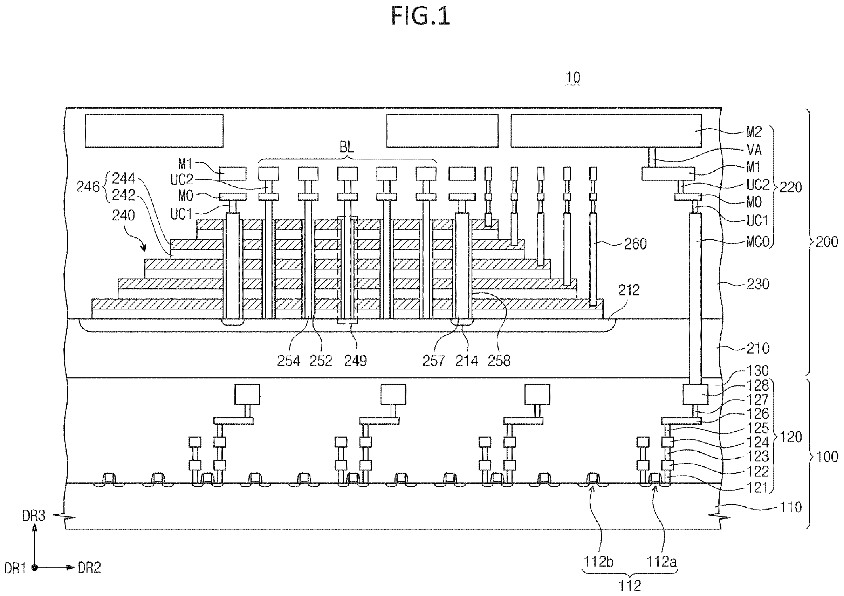

FIG. 1 is a cross-sectional view of a semiconductor memory device according to the present disclosure. FIG. 1 illustrates some example embodiments of a flash memory among semiconductor memory devices. Specifically, among the flash memories, a vertical NAND flash memory (VNAND) is illustrated.

Referring to FIG. 1, the semiconductor memory device 10 may have a cell on peripheral (COP) structure in which a cell region 200 is stacked on a peripheral region 100. At least a portion of the peripheral region 100 and at least a portion of the cell region 200 may vertically overlap each other.

The peripheral region 100 may include one or more peripheral transistors 112 disposed on the lower substrate 110, peripheral circuit lines 120 electrically connected to the peripheral transistors 112, and the lower insulating layer 130 covering the peripheral circuit lines 120 and the peripheral transistors 112. The lower substrate 110 may include a semiconductor substrate. For example, the lower substrate 110 may include Si, Ge, and/or SiGe. In one example, the lower substrate 110 may include a poly silicon substrate, a silicon-on-insulator (SOI) substrate, and/or a germanium-on-insulator (GeOI) substrate.

The peripheral transistor 112 may include a high voltage transistor 112a and a low voltage transistor 112b. For example, the high voltage transistor 112a may be a bit line selection transistor, and the low voltage transistor 112b may be a bit line shut-off transistor included in a page buffer described below. The high voltage transistor 112a may include a high voltage source/drain region to which a high voltage is applied and a low voltage source/drain region to which a low voltage is applied. In one example, the high voltage source/drain region of the high voltage transistor 112a may be electrically connected to a bit line BL described below, and the low voltage source/drain region may be electrically connected to the source/drain region of the low voltage transistor 112b. A low voltage may be applied to the source/drain regions of the low voltage transistor 112b.

The peripheral circuit line 120 may include a first lower line 122, a second lower line 124, a middle line 126, and an upper line 128 sequentially stacked on the lower substrate 110. The peripheral circuit line 120 may further include a first lower contact 121 electrically connecting the peripheral transistor 112 to the first lower line 122, the second lower contact 123 electrically connecting the first lower line 122 to the second lower line 124, the third lower contact 125 electrically connecting the second lower line 124 to the middle line 126, and a fourth lower contact 127 electrically connecting the middle line 126 to the upper line 128. The peripheral circuit line 120 will be described below in detail.

The lower insulating layer 130 may cover the high voltage transistors 112a, the first lower lines 122, the second lower line 124, the middle line 126, the upper line 128, the first lower contact 121, the second lower contact 123, the third lower contact 125, and the fourth lower contact 127. The first lower lines 122, the second lower line 124, the middle line 126, the upper line 128, the first lower contact 121, the second lower contact 123, the third lower contact 125, and the fourth lower contact 127 may be disposed in the lower insulating layer 130. The lower insulating layer 130 may include an electrical insulating material. For example, the lower insulating layer 130 may include silicon oxide (e.g., SiO2), silicon nitride (e.g., SiN), and/or silicon oxynitride (e.g., SiON).

The cell region 200 may include an upper substrate 210, a cell array 240 disposed on the upper substrate 210, and an upper insulating layer 230 covering the cell array 240. The cell region 200 may further include a connecting circuit line 220 electrically connecting the cell array 240 and the peripheral circuit line 120. The cell array 240 may have a three-dimensional structure in which a plurality of cells are vertically stacked on an upper substrate 210 having a well region 212. The gate plugs 260 may electrically connect a plurality of cells of the cell array 240 to the circuit line 220.

The connecting circuit line 220 may be electrically connected to the peripheral circuit line 120. The connecting circuit line 220 may include a lower connecting line M0, a middle connecting line M1, and an upper connecting line M2 sequentially stacked on the cell array 240. The connecting circuit line 220 may further include a connecting contact MC0 electrically connecting the peripheral circuit line 120 to the connecting circuit line 220, a first upper contact UC1 electrically connecting the connecting contact MC0 to the lower connecting line M0, a second upper contact UC2 electrically connecting the lower connecting line M0 to the middle connecting line M1, and a via VA electrically connecting the middle connecting line M1 to the upper connecting line M2.

The first upper contact UC1 may connect the cell array 240 to the lower connecting line M0. The second upper contact UC2 may connect the lower connecting line M0 to the middle connecting line M1. The middle connecting line M1 may include a bit line BL electrically connected to the vertical channel of the cell array 240. The bit line BL may extend along the first direction DR1. The bit lines BL may be arranged along a second direction DR2 crossing the first direction DR1.

The upper substrate 210 may include a semiconductor substrate. For example, the upper substrate 210 may include Si, Ge, or SiGe. In one example, the upper substrate 210 may include a poly silicon substrate, a silicon-on-insulator (SOI) substrate, or a germanium-on-insulator (GeOI) substrate. The well region 212 may be a p-type well formed by doping the upper substrate 210 with p-type impurities. However, it is not limited thereto, and the well region 212 may be an n-type well. Also, the well region 212 may be formed by overlapping a p-type well and an n-type well.

The cell array 240 may include a gate stack 246 provided on the well region 212 of the upper substrate 210. The gate stack 246 may include insulating layers 242 and gates 244 alternately stacked on the upper substrate 210 along the third direction DR3 (e.g., a vertical direction). The third direction DR3 may cross the first and second directions DR1 and DR2. For example, the first to third directions DR1, DR2, and DR3 may be perpendicular to each other. The cell array 240 may include a vertical channel 254 that penetrates the gate stack 246 along the third direction DR3 and is electrically connected to the upper substrate 210, and a memory layer 252 extending along the vertical channel 254, a common source 214 formed in the well region 212 of the upper substrate 210, and a common source plug 257 electrically connected to the common source 214.

The common source plug 257 may be electrically insulated from the gates 244 by a plug insulating layer 258. The plug insulating layer 258 may include an electrical insulating material. For example, the plug insulating layer 258 may include silicon oxide (e.g., SiO2), silicon nitride (e.g., SiN), or silicon oxynitride (e.g., SiON). The common source plug 257 may be electrically connected to the lower metal line M0 through the first upper contact UC1.

An upper end of the vertical channel 254 may constitute a drain. The memory layer 252 may surround the vertical channel 254. As another example, the memory layer 252 may surround the gates 244. The vertical channel 254 may be electrically connected to the bit line BL through the lower connecting line M0, the middle connecting line M1, and the second upper contact UC2.

Among the gates 244, a lowermost gate 244 may form a ground selection line, the uppermost gate 244 may form a string selection line, and the remaining gates 244 may form word lines. The cell array 240 may be a vertical NAND (VNAND) flash memory. The gates 244 may be stacked in a stepwise manner to each have a pad to which the gate plugs 260 are connected. The gates 244 vertically stacked along one vertical channel 254 may constitute one memory cell string 249.

The gate plugs 260 may contact each of the pads of the gates 244. The gate plugs 260 may be electrically connected to the lower metal line M0 through the first upper contact UC1. Accordingly, the gates 244 may transmit and receive electrical signals to and from the peripheral region 100.

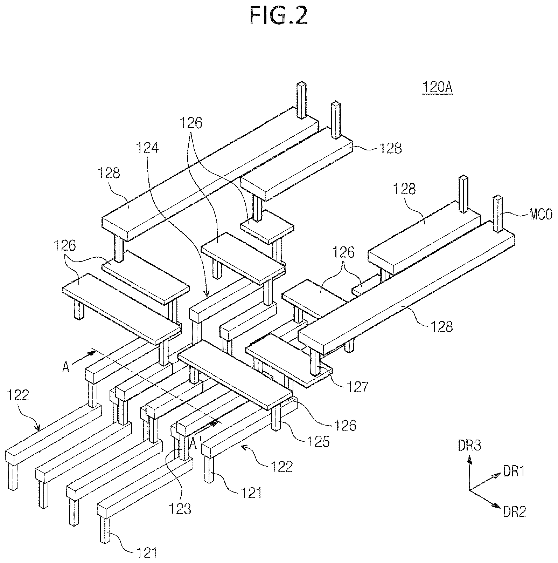

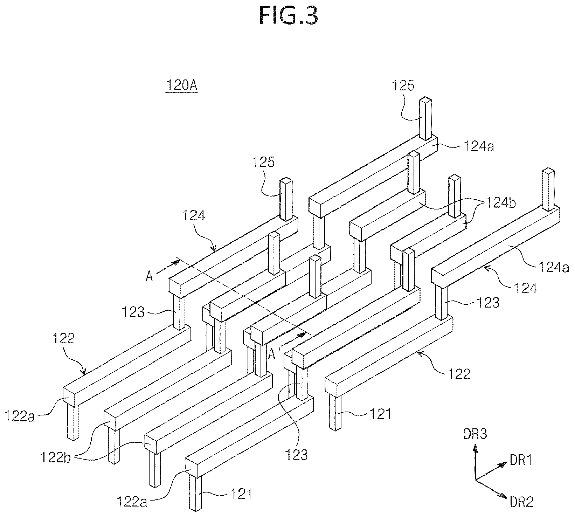

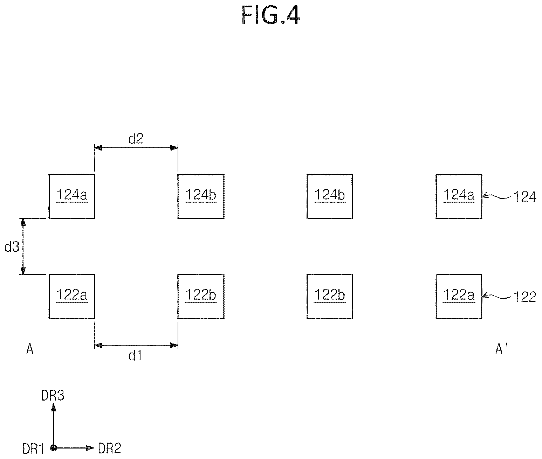

FIG. 2 is a diagram illustrating some example embodiments of peripheral circuit line of FIG. 1. FIG. 3 is a diagram illustrating first lower lines, second lower lines, first lower contacts, second lower contacts, and third lower contacts of FIG. 2. FIG. 4 is a cross-sectional view taken along the line A-A' of FIG. 2.

Referring to FIGS. 2 to 4, a peripheral circuit line 120A may be provided. The peripheral circuit line 120A includes first lower lines 122, a second lower line 124, a middle line 126, an upper line 128, a first lower contact 121, a second lower contact 123, a third lower contact 125, and a fourth lower contact 127. The peripheral circuit line 120A is illustrated as some example embodiments to explain the idea of the present disclosure.

The first lower lines 122 may include first high voltage lines 122a and first low voltage lines 122b. The first lower lines 122 may extend along the first direction DR1. The first lower lines 122 may be arranged along the second direction DR2. For example, the first lower lines 122 may be arranged at a substantially constant first gap d1. The first lower lines 122 may include an electrically conductive material. For example, the first lower lines 122 may include copper (Cu), aluminum (Al), tungsten (W), or a combination thereof.

The first high voltage lines 122a may be electrically connected to high voltage source/drain regions of the high voltage transistors 112a, respectively. For example, the first lower contacts 121 may be provided between the first high voltage lines 122a and the high voltage source/drain regions of the high voltage transistors 112a, respectively, to connect the first high voltage lines 122a and the high voltage source/drain regions of the high voltage transistors 112a.

The first low voltage lines 122b may be electrically connected to the low voltage source/drain regions of the high voltage transistors 112a, respectively. For example, the first lower contacts 121 may be provided between the first low voltage lines 122b and the low voltage source/drain regions of the high voltage transistors 112a, respectively, to connect the first low voltage lines 122b and the low voltage source/drain regions of the high voltage transistors 112a.

The first high voltage line 122a and the first low voltage line 122b may be separated from each other by a sufficient distance so as not to be electrically coupled to each other. In the present specification, non-occurrence of electrical coupling may refer to electrical coupling that does not affect, or does not substantially affect, the reliability of the semiconductor memory device as well as electrical coupling that does not occur at all.

The second lower lines 124 may include second high voltage lines 124a and second low voltage lines 124b. The second lower lines 124 may extend along the first direction DR1. The second lower lines 124 may be arranged along the second direction DR2. For example, the second lower lines 124 may be arranged at a substantially constant second gap d2. In one example, the second gap d2 may be the same as or substantially the same as the first gap d1, however the first and second gap d2 may be different. The second lower lines 124 may include an electrically conductive material. For example, the second lower lines 124 may include copper (Cu), aluminum (Al), tungsten (W), or a combination thereof.

The second high voltage lines 124a may be electrically connected to each of the first high voltage lines 122a. For example, second lower contacts 123 may be provided between the second high voltage lines 124a and the first high voltage lines 122a, respectively, to connect the second high voltage lines 124a and the first high voltage lines 122a. The second high voltage lines 124a may be electrically connected to the high voltage source/drain regions of the high voltage transistors 112a through the first high voltage lines 122a.

The second low voltage lines 124b may be electrically connected to each of the first low voltage lines 122b. For example, second lower contacts 123 may be provided between the second low voltage lines 124b and the first low voltage lines 122b, respectively, to connect the second low voltage lines 124b and the first low voltage lines 122b. The second low voltage lines 124b may be electrically connected to the low voltage source/drain regions of the high voltage transistors 112a through the first low voltage lines 122b.

The second high voltage line 124a and the second low voltage line 124b may be separated by a sufficient distance so as not to be electrically coupled to each other.

The second lower lines 124 may be located at a higher level than the first lower lines 122 in the third direction DR3. The second lower lines 124 may face the first lower lines 122 along the third direction DR3. The second lower lines 124 and the first lower lines 122 may be separated or apart from each other by a third gap d3 along the third direction DR3. The third gap d3 may be smaller than the first gap d1 and the second gap d2. When a line to which a low voltage is applied (e.g., the first low voltage line 122b and the second low voltage line 124b) and a line to which a high voltage is applied (e.g., the first high voltage line 122a and the second high voltage line 124b) are facing each other along the third direction DR3, electrical coupling may occur between a line to which a low voltage is applied and a line to which a high voltage is applied. According to the present disclosure, a line to which the low voltage is applied and a line to which the high voltage is applied are arranged so as not to face each other along the third direction DR3. A sufficient separation distance may be secured so that the line to which the low voltage is applied and the line to which the high voltage is applied are not electrical coupled.

The second high voltage line 124a and the first low voltage line 122b may be disposed not adjacent to each other along the third direction DR3. For example, the second high voltage line 124a and the first high voltage line 122a may be adjacent to each other along the third direction DR3.

The second low voltage line 124b and the first high voltage line 122a may be disposed not adjacent to each other along the third direction DR3. For example, the second low voltage line 124b and the first low voltage line 122b may be adjacent to each other along the third direction DR3.

The middle lines 126 may extend along the second direction DR2. The middle lines 126 may be arranged along the first direction DR1. The middle lines 126 may be positioned at a higher level than the second lower lines 124. A first group of the middle lines 126 may be electrically connected to the second high voltage lines 124a. For example, a third lower contacts 125 may be provided between the first group of the middle lines 126 and the second high voltage lines 124a, respectively, to connect the first group of the middle lines 126 and the second high voltage lines 124a.

A second group of the middle lines 126 may be electrically connected to the low voltage transistors, respectively. For example, third lower contacts 125, the second lower lines 124, second lower contacts 123, first lower lines 122, and first lower contacts 121 may be provided between the second group of the middle lines 126 and the low voltage transistors to connect the second group of the middle lines 126 and the low voltage transistors. The middle lines 126 may include an electrically conductive material. For example, the middle lines 126 may include copper (Cu), aluminum (Al), tungsten (W), or a combination thereof.

The upper lines 128 may extend along the first direction DR1. The upper lines 128 may be arranged along the second direction DR2. The upper lines 128 may be located at a higher level than the middle lines 126. The upper lines 128 may be electrically connected to the middle lines 126, respectively.

For example, fourth lower contacts 127 may be provided between the upper lines 128 and the middle lines 126, respectively, to connect the upper lines 128 and the middle lines 126. The upper lines 128 may be electrically connected to the bit lines BL through connecting contacts MC0. The upper lines 128 may include an electrically conductive material. For example, the upper lines 128 may include copper (Cu), aluminum (Al), tungsten (W), or a combination thereof.

As the degree of integration of the semiconductor memory device 10 increases, lines may be more densely (e.g., closely) arranged. When a line to which a high voltage is applied and a line to which a low voltage is applied are disposed too close to each other, the line to which a high voltage is applied and the line to which a low voltage is applied are electrically coupled, which may affect reliability and performance of the semiconductor memory device 10.

In the semiconductor memory device of the present disclosure, lines to which high voltage is applied (first high voltage line 122a and second high voltage line 124a) and lines to which low voltage is applied (first low voltage line 122b and second low voltage line 124b) may be sufficiently separated or apart from each other so that electrical coupling does not occur between them. Accordingly, electrical reliability of the semiconductor memory device 10 may be improved.

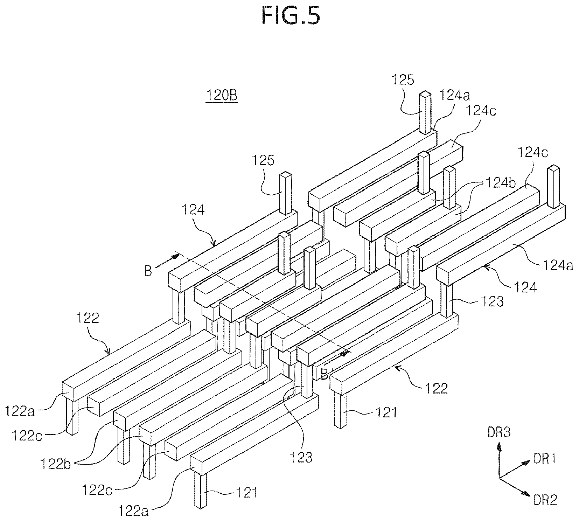

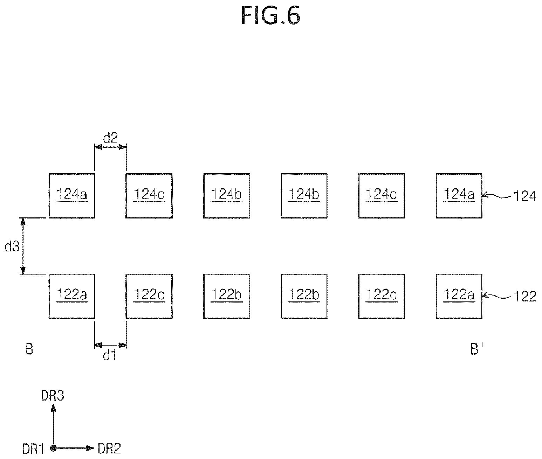

FIG. 5 is a diagram illustrating some example embodiments of peripheral circuit line of FIG. 1. FIG. 6 is a cross-sectional view taken along line B-B' of FIG. 5. For brevity of description, differences from the peripheral circuit line described with reference to FIGS. 2 to 4 are described.

Referring to FIGS. 5 and 6, a peripheral circuit line 120B may be provided. The peripheral circuit line 120B may include the first lower lines 122, the second lower line 124, the middle line, the upper line, the first lower contact 121, the second lower contact 123, and the third lower line 125. For brevity of description, the middle line, the upper line, and the fourth lower contact are not illustrated.

Unlike the description with reference to FIGS. 2 to 4, the first lower lines 122 may further include first dummy lines 122c. The first dummy lines 122c may not be electrically connected to other devices (e.g., the high voltage transistor 112a). For example, the first lower contacts 121 may not be provided between the first dummy lines 122c and the high voltage transistors 112a. The first lower lines 122 may extend along the first direction DR1. The first lower lines 122 may be arranged along the second direction DR2. For example, the first lower lines 122 may be arranged at a substantially constant first gap d1. In one example, the first gap d1 may be smaller than the third gap d3.

The first high voltage line 122a and the first low voltage line 122b may be disposed not immediately adjacent to each other. For example, the first high voltage line 122a and the first low voltage line 122b may be separated or apart from each other with the first dummy line 122c interposed therebetween. Accordingly, electrical coupling may not occur between the first high voltage line 122a and the first low voltage line 122b. The first high voltage lines 122a may be disposed immediately adjacent to or not adjacent to each other as needed. The first low voltage lines 122b may be disposed immediately adjacent to or not adjacent to each other as needed. Accordingly, electrical coupling may not occur between the second high voltage line 124a and the second low voltage line 124b.

The second lower lines 124 may further include second dummy lines 124c. The second dummy lines 124c may not be electrically connected to the first dummy lines 122c. For example, the second lower contacts 123 may not be provided between the second dummy lines 124c and the first dummy lines 122c. The second lower lines 124 may extend along the first direction DR1. The second lower lines 124 may be arranged along the second direction DR2. For example, the second lower lines 124 may be arranged at a substantially constant second gap d2. In one example, the second gap d2 may be substantially the same as the first gap d1. Accordingly, the second gap d2 may be smaller than the third gap d3.

The second high voltage line 124a and the second low voltage line 124b may be disposed not immediately adjacent to each other. For example, the second high voltage line 124a and the second low voltage line 124b may be separated or apart from each other with the second dummy line 124c interposed therebetween. The second high voltage lines 124a may be disposed immediately adjacent to or not adjacent to each other as needed. The second low voltage lines 124b may be disposed immediately adjacent to or not adjacent to each other as needed.

In the semiconductor memory device of the present disclosure, lines to which high voltage is applied (e.g., first high voltage line 122a and second high voltage line 124a) and lines to which low voltage is applied (e.g., first low voltage line 122b and second low voltage line 124b) are configured so that electrical coupling does not occur between them. Therefore, the semiconductor memory device of the present disclosure may have high reliability.

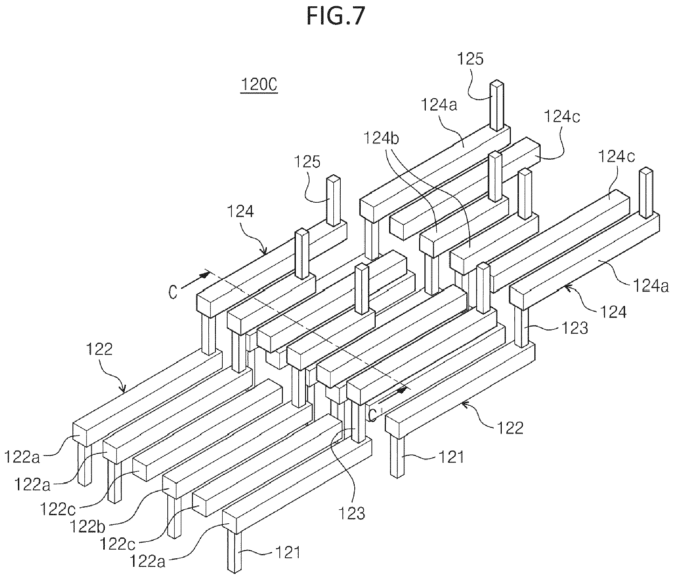

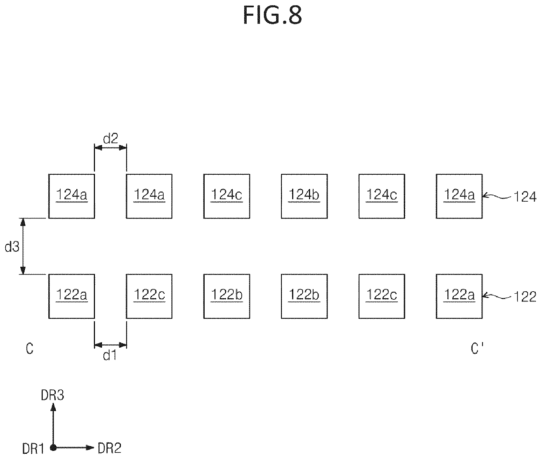

FIG. 7 is a diagram illustrating some example embodiments of peripheral circuit line of FIG. 1. FIG. 8 is a cross-sectional view taken along line C-C' of FIG. 7. For brevity of description, differences from the peripheral circuit line described with reference to FIGS. 5 and 6 are described.

Referring to FIGS. 7 and 8, a peripheral circuit line 120C may be provided. The peripheral circuit line 120C may include first lower lines 122, a second lower line 124, a middle line, an upper line, a first lower contact 121, a second lower contact 123, a third lower contact 125, and a fourth lower contact. For brevity of description, the middle line, the upper line, and the fourth lower contact are not illustrated.

Unlike those described with reference to FIGS. 5 and 6, the at least one second high voltage line 124a and the at least one second dummy line 124c may face the first dummy line 122c and the first low voltage line 122b along the third direction DR3, respectively. Accordingly, the second high voltage line 124a and the second low voltage line 124b may be disposed not adjacent to each other along the third direction DR3 with the first low voltage line 122b and the first high voltage line 122a, respectively. That is, the second lower lines 124 of the peripheral circuit line 120C may be such that a second high voltage line 124a, a second low voltage line 124b, a second dummy line 124c, a second low voltage line 124b, a second dummy line 124c, and a second high voltage line 124a are arranged in the second direction D2. The first lower lines 122 of the peripheral circuit line 120C may have the same arrangement.

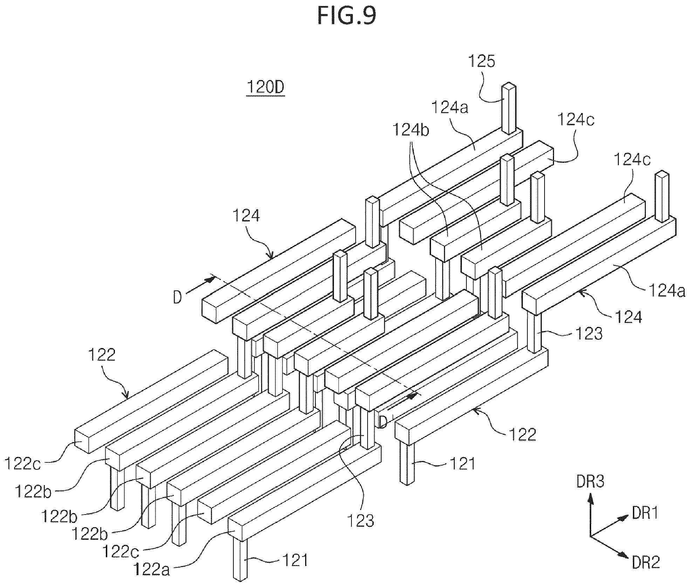

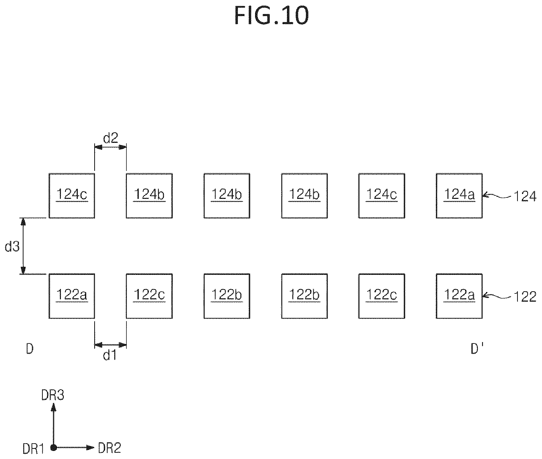

FIG. 9 is a diagram illustrating some example embodiments of the peripheral circuit line of FIG. 1. FIG. 10 is a cross-sectional view taken along line D-D' of FIG. 9. For brevity of description, differences from the peripheral circuit line described with reference to FIGS. 5 and 6 are described.

Referring to FIGS. 9 and 10, a peripheral circuit line 120D may be provided. The peripheral circuit line 120D may include first lower lines 122, a second lower line 124, a middle line, an upper line, a first lower contact 121, a second lower contact 123, a third lower contact 125, a fourth lower contact. For brevity of description, the middle line, the upper line, and the fourth lower contact are not illustrated.

Unlike those described with reference to FIGS. 5 and 6, the at least one second low voltage line 124b and the at least one second dummy line 124c may face the first dummy line 122c and the first high voltage line 122a along the third direction DR3, respectively. Accordingly, the second high voltage line 124a and the second low voltage line 124b may be disposed not adjacent to each other along the third direction DR3 with the first low voltage line 122b and the first high voltage line 122a, respectively. That is, the second lower lines 124 of the peripheral circuit line 120D may be such that a second dummy voltage line 124c, a second high voltage line 124a, a second low voltage line 124b, a second low voltage line 124b, a second dummy line 124c, and a second high voltage line 124a are arranged in the second direction D2. The first lower lines 122 of the peripheral circuit line 120D may have the same arrangement.

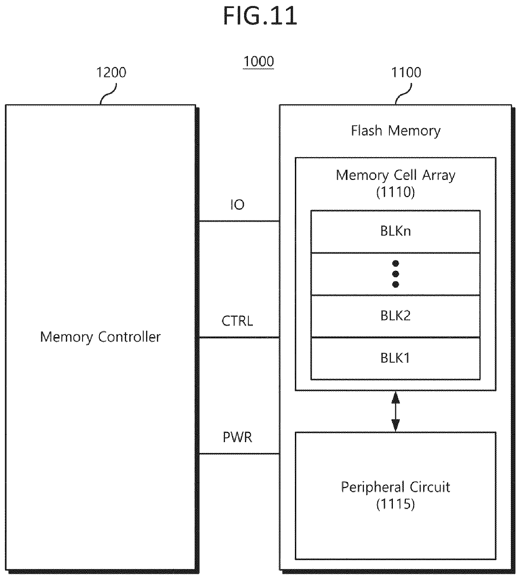

FIG. 11 is a block diagram illustrating a storage device including the semiconductor memory device illustrated in FIG. 1. The storage device 1000 may be a flash storage device based on the flash memory 1100. For example, the storage device 1000 may be an SSD, a UFS, or a memory card.

Referring to FIG. 11, a storage device 1000 includes a flash memory 1100 and a memory controller 1200. The flash memory 1100 and the memory controller 1200 may be connected through data input/output lines IO, control line CTRL, and power supply lines PWR. The storage device 1000 may store data in the flash memory 1100 under the control of the memory controller 1200.

The flash memory 1100 may include a memory cell array 1110 and a peripheral circuit 1115. The memory cell array 1110 may include a plurality of memory blocks BLK1 to BLKn. Each memory block may have a vertical 3D structure. Each memory block may include a plurality of memory cells. Multi-bit data may be stored in each memory cell.

The memory cell array 1110 may be positioned next to or above the peripheral circuit 1115 in terms of the design layout structure. A structure in which the memory cell array 1110 is positioned over the peripheral circuit 1115 is referred to as a cell on peripheral (COP) structure. Meanwhile, the memory cell array 1110 may be manufactured as a chip separate from the peripheral circuit 1115. An upper chip including the memory cell array 1110 and a lower chip including the peripheral circuit 1115 may be connected to each other by a bonding method. Such a structure is called a C2C (chip to chip) structure.

The peripheral circuit 1115 may include all analog circuits or digital circuits required to store data in the memory cell array 1110 or read data stored in the memory cell array 1110. The peripheral circuit 1115 may receive external power (PWR) from the memory controller 1200 and generate internal power (e.g., Vcc) of various levels.

The peripheral circuit 1115 may receive commands, addresses, and data from the memory controller 1200 through the input/output lines IO. The peripheral circuit 1115 may store data in the memory cell array 1110 according to control of the control signals CTRL. Also, the peripheral circuit 1115 may read data stored in the memory cell array 1110 and provide the data to the memory controller 1200.

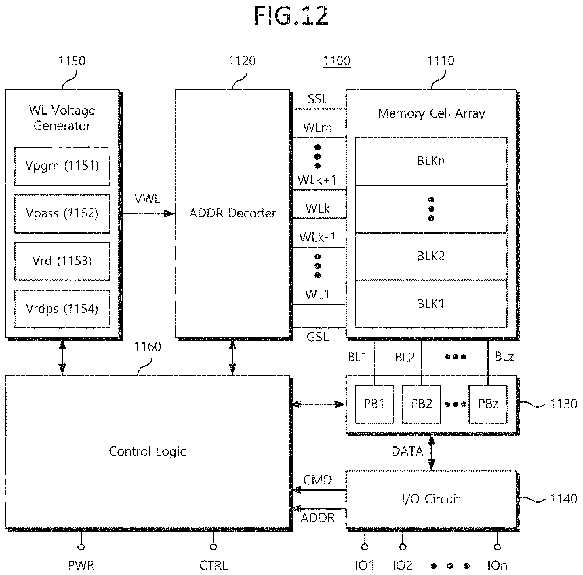

FIG. 12 is a block diagram illustrating the flash memory illustrated in FIG. 11 according to some example embodiments. Referring to FIG. 12, a flash memory 1110 includes a memory cell array 1110, an address decoder 1120, a page buffer circuit 1130, a data input/output circuit 1140, a word line voltage generator 1150, and a control logic 1160.

The memory cell array 1110 may include a plurality of memory blocks BLK1 to BLKn. Each memory block may be composed of a plurality of pages. Each page may include a plurality of memory cells. Multi-bit data may be stored in each memory cell. Each memory block is an erase unit, and each page may be a read or write unit.

The memory cell array 1110 may be formed in a direction perpendicular to the substrate. A gate electrode layer and an insulation layer may be alternately deposited on the substrate. Each memory block (e.g., BLK1) may be connected to a string selection line SSL, a plurality of word lines WL1 to WLm, and a ground selection line GSL.

The address decoder 1120 may be connected with the memory cell array 1110 through the selection lines SSL and GSL, and the word lines WL1 to WLm. The address decoder 1120 may select a word line in the program or read operation. The address decoder 1120 may receive a word line voltage VWL from the voltage generator 1150 and may provide the selected word line with the program voltage or the read voltage.

The page buffer circuit 1130 may be connected with the memory cell array 1110 through bit lines BL1~BLz. The page buffer circuit 1130 may temporarily store data to be programmed in the memory cell array 1110 or data read from the memory cell array 1110. The page buffer circuit 1130 may include page buffers PB1~PBz that are connected with each bit lines BLs. Each page buffer may include a plurality of latches for the purpose of storing or reading multi-bit data.

The data input/output circuit 1140 may be internally connected with the page buffer circuit 1130 through data lines and may be externally connected with the memory controller 1200 (refer to FIG. 11) through input/output lines IO1 to IOn. During the program operation, the data input/output circuit 1140 may receive program data from the memory controller 1200. During the read operation, the data input/output circuit 1140 may provide the memory controller 1200 with data read from the memory cell array 1110.

The word line voltage generator 1150 may be supplied with an internal power from the control logic 1160 and may generate the word line voltage VWL used to read or write data. The word line voltage VWL may be provided to a selected word line sWL or unselected word lines uWL through the address decoder 1120.

The word line voltage generator 1150 may include a program voltage generator 1151 and a pass voltage generator 1152. The program voltage generator 1151 may generate a program voltage Vpgm provided to the selected word line sWL during a program operation. The pass voltage generator 1152 may generate a pass voltage Vpass provided to the selected word line sWL and the unselected word line uWL.

The word line voltage generator 1150 may include a read voltage generator 1153 and a read pass voltage generator 1154. The read voltage generator 1153 may generate the select read voltage Vrd provided to the select word line sWL during a read operation. The read pass voltage generator 1154 may generate a read pass voltage Vrdps provided to the unselected word line uWL. The read pass voltage Vrdps may be a voltage sufficient to turn on memory cells connected to the unselected word line uWL during a read operation.

The control logic 1160 may control the program, read, and erase operations of the flash memory device 1100 by using a command CMD, an address ADDR, and the control signal CTRL provided from the memory controller 1200. The address ADDR may include a block address (or block selection address) that indicates, and may be used for selecting, one memory block, and a row address and a column address that indicate, and may be used for selecting, one memory cell of the selected memory block.

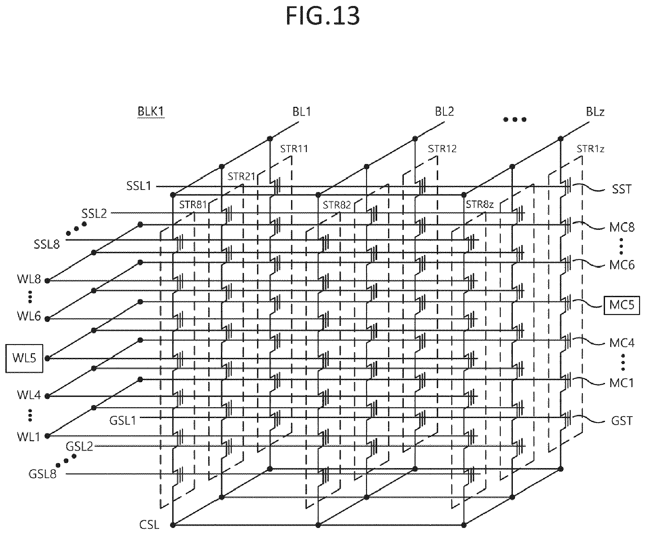

FIG. 13 is a circuit diagram illustrating some example embodiments of a memory block BLK1 of the memory cell array illustrated in FIG. 12. Referring to FIG. 13, in the memory block BLK1, a plurality of cell strings STR11 to STR8z may be formed between the bit lines BL1 to BLz and a common source line CSL. Each cell string includes a string selection transistor SST, a plurality of memory cells MC1 to MC8, and a ground selection transistor GST.

The string selection transistors SST may be connected with string selection lines SSL1 to SSL8. The ground selection transistors GST may be connected with ground selection lines GSL1 to GSL8. The string selection transistors SST may be connected with the bit lines BL1 to BLz, and the ground selection transistors GST may be connected with the common source line CSL.

The first to eighth word lines WL1 to WL8 may be connected with the plurality of memory cells MC1 to MC8 in a row direction. The first to z-th bit lines BL1 to BLz may be connected with the plurality of memory cells MC1 to MC8 in a column direction. First to z-th page buffers PB1 to PBz may be connected with the first to z-th bit lines BL1 to BLz.

The first word line WL1 may be placed above the first to eighth ground selection lines GSL1 to GSL8. The first memory cells MC1 that are placed at the same height from the substrate may be connected with the first word line WL1. Likewise, the second to eighth memory cells MC2 to MC8 that are placed at the same heights from the substrate may be respectively connected with the second to eighth word lines WL2 to WL8.

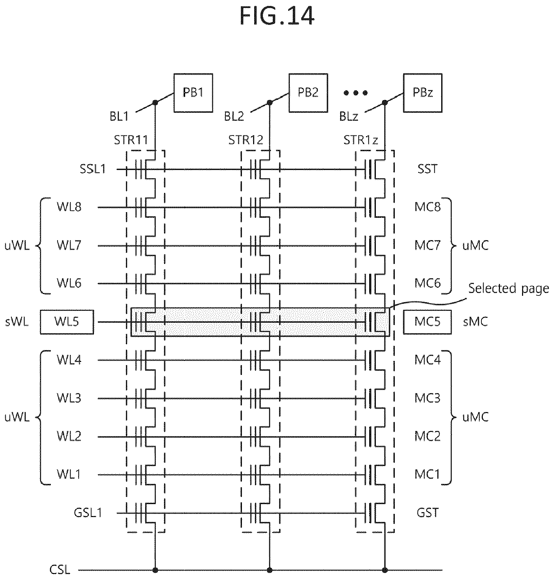

FIG. 14 is a circuit diagram illustrating cell strings selected by the first string selection line SSL1 from among cell strings of the memory block BLK1 illustrated in FIG. 13. The cell strings STR11 to STRIz may be selected by the first string selection line SSL1. The cell strings STR11 to STRIz may be respectively connected with the first to z-th bit lines BL1 to BLz. First to z-th page buffers PB1 to PBz may be respectively connected with the first to z-th bit lines BL1 to BLz.

The cell string STR11 is connected with the first bit line BL1 and the common source line CSL. The string selection transistor SST selected by the first string selection line SSL1, the first to eighth memory cells MC1 to MC8 connected with the first to eighth word lines WL1 to WL8, and the ground selection transistors GST selected by the first ground selection line GSL1 may be included in the cell string STR11. Likewise, the 1-2nd cell string STR12 may be connected with the second bit line BL2 and the common source line CSL, and the cell string STR1z may be connected with the z-th bit line BLz and the common source line CSL.

The first to fourth word lines WL1 to WL4 and the sixth to eight word lines WL6 to WL8 may be unselected word lines uWL. The fifth word line WL5 may be the selected word line sWL. The first to fourth memory cells MC1 to MC4 and the sixth to eight memory cells MC6 to MC8 may be unselected memory cells uMC. The fifth memory cell MC5 may be a selected memory cell sMC.

Memory cells that are selected by one string selection line and are connected with one word line may constitute one page. For example, the fifth memory cells MC5 that is selected by the first string selection line SSL1 and is connected with the fifth word line WL5 may constitute one page. In some example embodiments, eight pages may be implemented by using the memory cells connected with the fifth word line WL5. Among the eight pages, the page connected with the first string selection line SSL1 may be a selected page. However, the inventive concepts are not limited thereto, and more or less pages may be used.

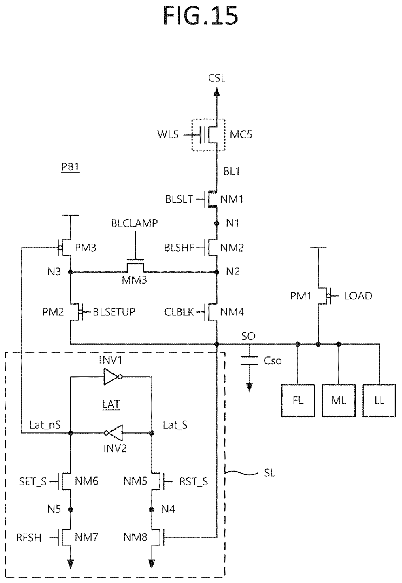

FIG. 15 is a circuit diagram illustrating some example embodiments of the first page buffer PB1 illustrated in FIG. 12. Referring to FIG. 15, the first page buffer PB1 is connected to the first bit line BL1. A fifth memory cell MC5 that is a selected memory cell sMC may be connected to the first bit line BL1. A fifth word line WL5 that is a selected word line sWL may be connected to the fifth memory cell MC5. The first bit line BL1 may be connected to the common source line CSL through the fifth memory cell MC5.

A first NMOS transistor NM1 may be included between the first bit line BL1 and the first node N1. The first NMOS transistor NM1 may be a bit line select transistor driven by the bit line select signal BLSLT. The bit line select transistor may be implemented as a high voltage transistor. The bit line select transistor may be disposed in the high voltage region.

A second NMOS transistor NM2 may be included between the first node N1 and the second node N2. The second NMOS transistor NM2 may be a bit line shut-off transistor driven by the bit line shut-off signal BLSHF. A third NMOS transistor NM3 may be included between the second node N2 and the third node N3. The third NMOS transistor NM3 may be a bit line clamping transistor driven by the bit line clamping control signal BLCLAMP. A fourth NMOS transistor NM4 may be included between the second node N2 and the sensing node SO. The fourth NMOS transistor NM4 may be a bit line connection transistor driven by the bit line connection control signal CLBLK.

A first PMOS transistor PM1 may be included between the sensing node SO and the power terminal. The first PMOS transistor PM1 may be a precharge load transistor driven by the load signal LOAD. A second PMOS transistor PM2 may be included between the sensing node SO and the third node NM3. The second PMOS transistor PM2 may be a bit line setup transistor driven by the bit line setup signal BLSETUP. A third PMOS transistor PM3 may be included between the third node NM3 and the power terminal. The third PMOS transistor PM3 may be a precharge transistor driven by the inverted latch node Lat_nS.

A sensing latch SL, a force latch FL, a most significant bit latch ML, and a least significant bit latch LL may be connected to the sensing node SO. The sensing latch SL may store data stored in the selected memory cell sMC or a sensing result of the threshold voltage of the selected memory cell sMC during a read or program verify operation. Also, the sensing latch SL may be used to apply a program bit line voltage or a program inhibit voltage to the first bit line BL1 during a program operation. The force latch FL may be used to improve threshold voltage distribution during a program operation. The most significant bit latch ML and the least significant bit latch LL may be utilized to store data inputted from the outside during a program operation.

The sensing latch SL may include a latch LAT connected between the latch node Lat_S and the inverted latch node Lat_nS. The latch LAT may include first and second inverters INV1 and INV2. An input terminal of the first inverter INV1 and an output terminal of the second inverter INV2 may be connected to the inverted latch node Lat_nS. An output terminal of the first inverter INV1 and an input terminal of the second inverter INV2 may be connected to the latch node Lat_S.

The inverted latch node Lat_nS may be connected to the gate terminal of the third PMOS transistor PM3. When the inverted latch node Lat_nS is at a low level, the third PMOS transistor PM3 may be turned on, and the third node N3 may become a power supply voltage level. When the inverted latch node Lat_nS is at a high level, the power terminal and the third node N3 may be cut off.

A fifth NMOS transistor NM5 may be included between the latch node Lat_S and the fourth node N4. The fifth NMOS transistor NM5 may be used to reset the latch node Lat_S in response to the latch reset signal RST_S. The latch reset signal RST_S may be provided from the control logic (refer to FIG. 12, control logic 1160). A sixth NMOS transistor NM6 may be included between the inverted latch node Lat_nS and the fifth node N5. The sixth NMOS transistor NM6 may be used to set the latch node Lat_S in response to the latch set signal SET_S. The latch set signal SET_S may be provided from the control logic (refer to FIG. 12, control logic 1160).

A seventh NMOS transistor NM7 may be included between the fifth node N5 and the ground terminal. The seventh NMOS transistor NM7 may adjust the voltage level of the fifth node N5 in response to the refresh signal RFSH. The refresh signal RFSH may be provided from the control logic (refer to FIG. 2, control logic 1160). An eighth NMOS transistor NM8 may be included between the fourth node N4 and the ground terminal. The eighth NMOS transistor NM8 may adjust the voltage level of the fourth node N4 in response to the voltage level of the sensing node SO.

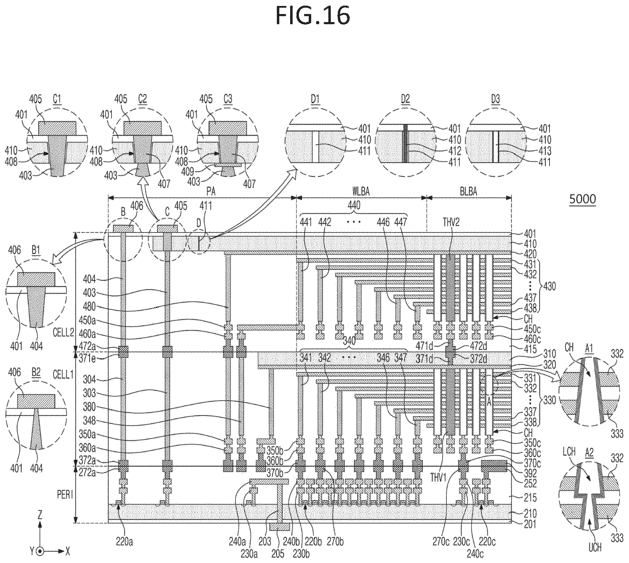

FIG. 16 is a view illustrating a memory device according to some example embodiments of the present disclosure.

Referring to FIG. 16, the memory device 6000 may have a chip-to-chip (C2C) structure. At least one upper chip including a cell region and a lower chip including a peripheral circuit region PERI may be manufactured separately, and then, the at least one upper chip and the lower chip may be connected to each other by a bonding method to realize the C2C structure. For example, the bonding method may mean a method of electrically or physically connecting a bonding metal pattern formed in an uppermost metal layer of the upper chip to a bonding metal pattern formed in an uppermost metal layer of the lower chip. For example, in a case in which the bonding metal patterns are formed of copper (Cu), the bonding method may be a Cu-Cu bonding method. Alternatively, the bonding metal patterns may be formed of aluminum (Al) and/or tungsten (W).

The memory device 6000 may include the at least one upper chip including the cell region. For example, the memory device 6000 may include two upper chips. However, the number of the upper chips is not limited thereto. In the case in which the memory device 6000 includes the two upper chips, a first upper chip including a first cell region CELL1, a second upper chip including a second cell region CELL2 and the lower chip including the peripheral circuit region PERI may be manufactured separately, and then, the first upper chip, the second upper chip and the lower chip may be connected to each other by the bonding method to manufacture the memory device 6000. The first upper chip may be turned over and then may be connected to the lower chip by the bonding method, and the second upper chip may also be turned over and then may be connected to the first upper chip by the bonding method. Hereinafter, upper and lower portions of each of the first and second upper chips will be defined based on before each of the first and second upper chips is turned over. In other words, an upper portion of the lower chip may mean an upper portion defined based on a +Z-axis direction, and the upper portion of each of the first and second upper chips may mean an upper portion defined based on a -Z-axis direction. However, example embodiments of the inventive concepts are not limited thereto. In some example embodiments, one of the first upper chip and the second upper chip may be turned over and then may be connected to a corresponding chip by the bonding method.

Each of the peripheral circuit region PERI and the first and second cell regions CELL1 and CELL2 of the memory device 6000 may include an external pad bonding region PA, a word line bonding region WLBA, and a bit line bonding region BLBA.

The peripheral circuit region PERI may include a first substrate 210 and a plurality of circuit elements 220a, 220b and 220c formed on the first substrate 210. An interlayer insulating layer 215 including one or more insulating layers may be provided on the plurality of circuit elements 220a, 220b and 220c, and a plurality of metal lines electrically connected to the plurality of circuit elements 220a, 220b and 220c may be provided in the interlayer insulating layer 215. For example, the plurality of metal lines may include first metal lines 230a, 230b and 230c connected to the plurality of circuit elements 220a, 220b and 220c, and second metal lines 240a, 240b and 240c formed on the first metal lines 230a, 230b and 230c. The plurality of metal lines may be formed of at least one of various conductive materials. For example, the first metal lines 230a, 230b and 230c may be formed of tungsten having a relatively high electrical resistivity, and the second metal lines 240a, 240b and 240c may be formed of copper having a relatively low electrical resistivity.

The first metal lines 230a, 230b and 230c and the second metal lines 240a, 240b and 240c are illustrated and described in the some example embodiments. However, example embodiments of the inventive concepts are not limited thereto. In some example embodiments, at least one or more additional metal lines may further be formed on the second metal lines 240a, 240b and 240c. In this case, the second metal lines 240a, 240b and 240c may be formed of aluminum, and at least some of the additional metal lines formed on the second metal lines 240a, 240b and 240c may be formed of copper having an electrical resistivity lower than that of aluminum of the second metal lines 240a, 240b and 240c.

The interlayer insulating layer 215 may be disposed on the first substrate 210 and may include an insulating material such as silicon oxide and/or silicon nitride.

Each of the first and second cell regions CELL1 and CELL2 may include at least one memory block. The first cell region CELL1 may include a second substrate 310 and a common source line 320. A plurality of word lines 330 (for example, including word lines 331 to 338) may be stacked on the second substrate 310 in a direction (e.g., the Z-axis direction) perpendicular to a top surface of the second substrate 310. String selection lines and a ground selection line may be disposed on and under the word lines 330, and the plurality of word lines 330 may be disposed between the string selection lines and the ground selection line. Likewise, the second cell region CELL2 may include a third substrate 410 and a common source line 420, and a plurality of word lines 430 (for example, including word lines 431 to 438) may be stacked on the third substrate 410 in a direction (e.g., the Z-axis direction) perpendicular to a top surface of the third substrate 410. Each of the second substrate 310 and the third substrate 410 may be formed of at least one of various materials and may be, for example, a silicon substrate, a silicon-germanium substrate, a germanium substrate, or a substrate having a single-crystalline epitaxial layer grown on a single-crystalline silicon substrate. A plurality of channel structures CH may be formed in each of the first and second cell regions CELL1 and CELL2.

In some example embodiments, as illustrated in a region 'A1', the channel structure CH may be provided in the bit line bonding region BLBA and may extend in the direction perpendicular to the top surface of the second substrate 310 to penetrate the word lines 330, the string selection lines, and the ground selection line. The channel structure CH may include a data storage layer, a channel layer, and a filling insulation layer. The channel layer may be electrically connected to a first metal line 350c and a second metal line 360c in the bit line bonding region BLBA. For example, the second metal line 360c may be a bit line and may be connected to the channel structure CH through the first metal line 350c. The bit line 360c may extend in a first direction (e.g., a Y-axis direction) parallel to the top surface of the second substrate 310.

In some example embodiments, as illustrated in a region 'A2', the channel structure CH may include a lower channel LCH and an upper channel UCH, which are connected to each other. For example, the channel structure CH may be formed by a process of forming the lower channel LCH and a process of forming the upper channel UCH. The lower channel LCH may extend in the direction perpendicular to the top surface of the second substrate 310 to penetrate the common source line 320 and lower word lines 331 and 332. The lower channel LCH may include a data storage layer, a channel layer, and a filling insulation layer and may be connected to the upper channel UCH. The upper channel UCH may penetrate upper word lines 333 to 338. The upper channel UCH may include a data storage layer, a channel layer, and a filling insulation layer, and the channel layer of the upper channel UCH may be electrically connected to the first metal line 350c and the second metal line 360c. As a length of a channel increases, due to characteristics of manufacturing processes, it may be difficult to form a channel having a substantially uniform width. The memory device 6000 according to the some example embodiments may include a channel having improved width uniformity due to the lower channel LCH and the upper channel UCH which are formed by the processes performed sequentially.

In the case in which the channel structure CH includes the lower channel LCH and the upper channel UCH as illustrated in the region 'A2', a word line located near to a boundary between the lower channel LCH and the upper channel UCH may be a dummy word line. For example, the word lines 332 and 333 adjacent to the boundary between the lower channel LCH and the upper channel UCH may be the dummy word lines. In this case, data may not be stored in memory cells connected to the dummy word line. Alternatively, the number of pages corresponding to the memory cells connected to the dummy word line may be less than the number of pages corresponding to the memory cells connected to a general word line. A level of a voltage applied to the dummy word line may be different from a level of a voltage applied to the general word line, and thus it is possible to reduce an influence of a non-uniform channel width between the lower and upper channels LCH and UCH on an operation of the memory device.

Meanwhile, the number of the lower word lines 331 and 332 penetrated by the lower channel LCH is less than the number of the upper word lines 333 to 338 penetrated by the upper channel UCH in the region 'A2'. However, example embodiments of the inventive concepts are not limited thereto. In some example embodiments, the number of the lower word lines penetrated by the lower channel LCH may be equal to or more than the number of the upper word lines penetrated by the upper channel UCH. In addition, structural features and connection relation of the channel structure CH disposed in the second cell region CELL2 may be substantially the same as those of the channel structure CH disposed in the first cell region CELL1.

In the bit line bonding region BLBA, a first through-electrode THV1 may be provided in the first cell region CELL1, and a second through-electrode THV2 may be provided in the second cell region CELL2. The first through-electrode THV1 may penetrate the common source line 320 and the plurality of word lines 330. In some example embodiments, the first through-electrode THV1 may further penetrate the second substrate 310. The first through-electrode THV1 may include a conductive material. Alternatively, the first through-electrode THV1 may include a conductive material surrounded by an insulating material. The second through-electrode THV2 may have the same shape and structure as the first through-electrode THV1.

In some example embodiments, the first through-electrode THV1 and the second through-electrode THV2 may be electrically connected to each other through a first through-metal pattern 372d and a second through-metal pattern 472d. The first through-metal pattern 372d may be formed at a bottom end of the first upper chip including the first cell region CELL1, and the second through-metal pattern 472d may be formed at a top end of the second upper chip including the second cell region CELL2. The first through-electrode THV1 may be electrically connected to the first metal line 350c and the second metal line 360c. A lower via 371d may be formed between the first through-electrode THV1 and the first through-metal pattern 372d, and an upper via 471d may be formed between the second through-electrode THV2 and the second through-metal pattern 472d. The first through-metal pattern 372d and the second through-metal pattern 472d may be connected to each other by the bonding method.

In addition, in the bit line bonding region BLBA, an upper metal pattern 292 may be formed in an uppermost metal layer of the peripheral circuit region PERI, and an upper metal pattern 392 having the same shape as the upper metal pattern 292 may be formed in an uppermost metal layer of the first cell region CELL1. The upper metal pattern 392 of the first cell region CELL1 and the upper metal pattern 292 of the peripheral circuit region PERI may be electrically connected to each other by the bonding method. In the bit line bonding region BLBA, the bit line 360c may be electrically connected to a page buffer included in the peripheral circuit region PERI. For example, some of the circuit elements 220c of the peripheral circuit region PERI may constitute the page buffer, and the bit line 360c may be electrically connected to the circuit elements 220c constituting the page buffer through an upper bonding metal pattern 370c of the first cell region CELL1 and an upper bonding metal pattern 270c of the peripheral circuit region PERI.

In the word line bonding region WLBA, the word lines 330 of the first cell region CELL1 may extend in a second direction (e.g., an X-axis direction) parallel to the top surface of the second substrate 310 and may be connected to a plurality of cell contact plugs 340 (341 to 347). First metal lines 350b and second metal lines 360b may be sequentially connected onto the cell contact plugs 340 connected to the word lines 330. In the word line bonding region WLBA, the cell contact plugs 340 may be connected to the peripheral circuit region PERI through upper bonding metal patterns 370b of the first cell region CELL1 and upper bonding metal patterns 270b of the peripheral circuit region PERI.

The cell contact plugs 340 may be electrically connected to a row decoder included in the peripheral circuit region PERI. For example, some of the circuit elements 220b of the peripheral circuit region PERI may constitute the row decoder, and the cell contact plugs 340 may be electrically connected to the circuit elements 220b constituting the row decoder through the upper bonding metal patterns 370b of the first cell region CELL1 and the upper bonding metal patterns 270b of the peripheral circuit region PERI. In some example embodiments, an operating voltage of the circuit elements 220b constituting the row decoder may be different from an operating voltage of the circuit elements 220c constituting the page buffer. For example, the operating voltage of the circuit elements 220c constituting the page buffer may be greater than the operating voltage of the circuit elements 220b constituting the row decoder.

Likewise, in the word line bonding region WLBA, the word lines 430 of the second cell region CELL2 may extend in the second direction (e.g., the X-axis direction) parallel to the top surface of the third substrate 410 and may be connected to a plurality of cell contact plugs 440 (for example, including contact plugs 441 to 447). The cell contact plugs 440 may be connected to the peripheral circuit region PERI through an upper metal pattern of the second cell region CELL2 and lower and upper metal patterns and a cell contact plug 348 of the first cell region CELL1.

In the word line bonding region WLBA, the upper bonding metal patterns 370b may be formed in the first cell region CELL1, and the upper bonding metal patterns 270b may be formed in the peripheral circuit region PERI. The upper bonding metal patterns 370b of the first cell region CELL1 and the upper bonding metal patterns 270b of the peripheral circuit region PERI may be electrically connected to each other by the bonding method. The upper bonding metal patterns 370b and the upper bonding metal patterns 270b may be formed of aluminum, copper, and/or tungsten.

In the external pad bonding region PA, a lower metal pattern 371e may be formed in a lower portion of the first cell region CELL1, and an upper metal pattern 472a may be formed in an upper portion of the second cell region CELL2. The lower metal pattern 371e of the first cell region CELL1 and the upper metal pattern 472a of the second cell region CELL2 may be connected to each other by the bonding method in the external pad bonding region PA. Likewise, an upper metal pattern 372a may be formed in an upper portion of the first cell region CELL1, and an upper metal pattern 272a may be formed in an upper portion of the peripheral circuit region PERI. The upper metal pattern 372a of the first cell region CELL1 and the upper metal pattern 272a of the peripheral circuit region PERI may be connected to each other by the bonding method.

Common source line contact plugs 380 and 480 may be disposed in the external pad bonding region PA. The common source line contact plugs 380 and 480 may be formed of a conductive material such as a metal, a metal compound, and/or doped polysilicon. The common source line contact plug 380 of the first cell region CELL1 may be electrically connected to the common source line 320, and the common source line contact plug 480 of the second cell region CELL2 may be electrically connected to the common source line 420. A first metal line 350a and a second metal line 360a may be sequentially stacked on the common source line contact plug 380 of the first cell region CELL1, and a first metal line 450a and a second metal line 460a may be sequentially stacked on the common source line contact plug 480 of the second cell region CELL2.

Input/output pads 205, 405 and 406 may be disposed in the external pad bonding region PA. A lower insulating layer 201 may cover a bottom surface of the first substrate 210, and a first input/output pad 205 may be formed on the lower insulating layer 201. The first input/output pad 205 may be connected to at least one of a plurality of the circuit elements 220a disposed in the peripheral circuit region PERI through a first input/output contact plug 203 and may be separated from the first substrate 210 by the lower insulating layer 201. In addition, a side insulating layer may be disposed between the first input/output contact plug 203 and the first substrate 210 to electrically isolate the first input/output contact plug 203 from the first substrate 210.

An upper insulating layer 401 covering a top surface of the third substrate 410 may be formed on the third substrate 410. A second input/output pad 405 and/or a third input/output pad 406 may be disposed on the upper insulating layer 401. The second input/output pad 405 may be connected to at least one of the plurality of circuit elements 220a disposed in the peripheral circuit region PERI through second input/output contact plugs 403 and 303, and the third input/output pad 406 may be connected to at least one of the plurality of circuit elements 220a disposed in the peripheral circuit region PERI through third input/output contact plugs 404 and 304.

In some example embodiments, the third substrate 410 may not be disposed in a region in which the input/output contact plug is disposed. For example, as illustrated in a region 'B', the third input/output contact plug 404 may be separated from the third substrate 410 in a direction parallel to the top surface of the third substrate 410 and may penetrate an interlayer insulating layer 415 of the second cell region CELL2 so as to be connected to the third input/output pad 406. In this case, the third input/output contact plug 404 may be formed by at least one of various processes.

In some example embodiments, as illustrated in a region 'B1', the third input/output contact plug 404 may extend in a third direction (e.g., the Z-axis direction), and a diameter of the third input/output contact plug 404 may become progressively greater toward the upper insulating layer 401. In other words, a diameter of the channel structure CH described in the region 'A1' may become progressively less toward the upper insulating layer 401, but the diameter of the third input/output contact plug 404 may become progressively greater toward the upper insulating layer 401. For example, the third input/output contact plug 404 may be formed after the second cell region CELL2 and the first cell region CELL1 are bonded to each other by the bonding method.

In some example embodiments, as illustrated in a region 'B2', the third input/output contact plug 404 may extend in the third direction (e.g., the Z-axis direction), and a diameter of the third input/output contact plug 404 may become progressively less toward the upper insulating layer 401. In other words, like the channel structure CH in the region 'A1,' the diameter of the third input/output contact plug 404 may become progressively less toward the upper insulating layer 401. For example, the third input/output contact plug 404 may be formed together with the cell contact plugs 440 before the second cell region CELL2 and the first cell region CELL1 are bonded to each other.

In some example embodiments, the input/output contact plug may overlap with the third substrate 410. For example, as illustrated in a region 'C', the second input/output contact plug 403 may penetrate the interlayer insulating layer 415 of the second cell region CELL2 in the third direction (e.g., the Z-axis direction) and may be electrically connected to the second input/output pad 405 through the third substrate 410. In this case, a connection structure of the second input/output contact plug 403 and the second input/output pad 405 may be realized by various methods.

In some example embodiments, as illustrated in a region 'C1', an opening 408 may be formed to penetrate the third substrate 410, and the second input/output contact plug 403 may be connected directly to the second input/output pad 405 through the opening 408 formed in the third substrate 410. In this case, as illustrated in the region 'C1', a diameter of the second input/output contact plug 403 may become progressively greater toward the second input/output pad 405. However, example embodiments of the inventive concepts are not limited thereto, and in some example embodiments, the diameter of the second input/output contact plug 403 may become progressively less toward the second input/output pad 405.

In some example embodiments, as illustrated in a region 'C2', the opening 408 penetrating the third substrate 410 may be formed, and a contact 407 may be formed in the opening 408. An end of the contact 407 may be connected to the second input/output pad 405, and another end of the contact 407 may be connected to the second input/output contact plug 403. Thus, the second input/output contact plug 403 may be electrically connected to the second input/output pad 405 through the contact 407 in the opening 408. In this case, as illustrated in the region 'C2', a diameter of the contact 407 may become progressively greater toward the second input/output pad 405, and a diameter of the second input/output contact plug 403 may become progressively less toward the second input/output pad 405. For example, the second input/output contact plug 403 may be formed together with the cell contact plugs 440 before the second cell region CELL2 and the first cell region CELL1 are bonded to each other, and the contact 407 may be formed after the second cell region CELL2 and the first cell region CELL1 are bonded to each other.

In some example embodiments illustrated in a region 'C3', a stopper 409 may further be formed on a bottom end of the opening 408 of the third substrate 410, as compared with the example embodiments of the region 'C2'. The stopper 409 may be a metal line formed in the same layer as the common source line 420. Alternatively, the stopper 409 may be a metal line formed in the same layer as at least one of the word lines 430. The second input/output contact plug 403 may be electrically connected to the second input/output pad 405 through the contact 407 and the stopper 409.

Like the second and third input/output contact plugs 403 and 404 of the second cell region CELL2, a diameter of each of the second and third input/output contact plugs 303 and 304 of the first cell region CELL1 may become progressively less toward the lower metal pattern 371e or may become progressively greater toward the lower metal pattern 371e.

Meanwhile, in some example embodiments, a slit 411 may be formed in the third substrate 410. For example, the slit 411 may be formed at a certain position of the external pad bonding region PA. For example, as illustrated in a region 'D', the slit 411 may be located between the second input/output pad 405 and the cell contact plugs 440 when viewed in a plan view. Alternatively, the second input/output pad 405 may be located between the slit 411 and the cell contact plugs 440 when viewed in a plan view.

In some example embodiments, as illustrated in a region 'D1', the slit 411 may be formed to penetrate the third substrate 410. For example, the slit 411 may be used to prevent, or reduce the occurrence of, the third substrate 410 from being finely cracked when the opening 408 is formed. However, example embodiments of the inventive concepts are not limited thereto, and in some example embodiments, the slit 411 may be formed to have a depth ranging from about or exactly 60% to about or exactly 70% of a thickness of the third substrate 410.

In some example embodiments, as illustrated in a region 'D2', a conductive material 412 may be formed in the slit 411. For example, the conductive material 412 may be used to discharge a leakage current occurring in driving of the circuit elements in the external pad bonding region PA to the outside. In this case, the conductive material 412 may be connected to an external ground line.

In some example embodiments, as illustrated in a region 'D3', an insulating material 413 may be formed in the slit 411. For example, the insulating material 413 may be used to electrically isolate the second input/output pad 405 and the second input/output contact plug 403 disposed in the external pad bonding region PA from the word line bonding region WLBA. Since the insulating material 413 is formed in the slit 411, it is possible to prevent or reduce a voltage provided through the second input/output pad 405 from affecting a metal layer disposed on the third substrate 410 in the word line bonding region WLBA.

Meanwhile, in some example embodiments, the first to third input/output pads 205, 405 and 406 may be selectively formed. For example, the memory device 6000 may be realized to include only the first input/output pad 205 disposed on the first substrate 210, to include only the second input/output pad 405 disposed on the third substrate 410, to include only the third input/output pad 406 disposed on the upper insulating layer 401, or some other combination.

In some example embodiments, at least one of the second substrate 310 of the first cell region CELL1 or the third substrate 410 of the second cell region CELL2 may be used as a sacrificial substrate and may be completely or partially removed before or after a bonding process. An additional layer may be stacked after the removal of the substrate. For example, the second substrate 310 of the first cell region CELL1 may be removed before or after the bonding process of the peripheral circuit region PERI and the first cell region CELL1, and then, an insulating layer covering a top surface of the common source line 320 or a conductive layer for connection may be formed. Likewise, the third substrate 410 of the second cell region CELL2 may be removed before or after the bonding process of the first cell region CELL1 and the second cell region CELL2, and then, the upper insulating layer 401 covering a top surface of the common source line 420 or a conductive layer for connection may be formed.

When the terms "about" or "substantially" are used in this specification in connection with a numerical value, it is intended that the associated numerical value includes a manufacturing or operational tolerance (e.g., ±10 %) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10 %) around the stated numerical values or shapes.

The storage device 1000 (or other circuitry, for example, flash memory 1100, memory controller 1200, memory cell array 1110, peripheral circuit 1115, ADDR decoder 1120, page buffer circuit 1130, data input/output circuit 1140, word line voltage generator 1150, control logic 1160, or other subcomponents) may include hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

While the present disclosure has been described with reference to embodiments thereof, it will be apparent to those of ordinary skill in the art that various changes and modifications may be made thereto without departing from the scope of the following claims.

## Claims

1. A semiconductor memory device comprising:
a peripheral region (100) including
a lower substrate (110),
high voltage transistors (112a) on the lower substrate (110),
first lower lines (122) electrically connected to the high voltage transistors (112a), and
second lower lines (124) electrically connected to the first lower lines (122) over the first lower lines (122); and
a cell region (200) on the peripheral region (100),
the first lower lines (122) and the second lower lines (124) extending along a first direction (DR1) parallel to an upper surface of the lower substrate (110),
the first lower lines (122) including first high voltage lines (122a) and first low voltage lines (122b),
the second lower lines (124) including second high voltage lines (124a) and second low voltage lines (124b),
the second high voltage lines (124a) and the first low voltage lines (122b) being separated in a second direction (DR2) parallel to the upper surface of the lower substrate (110) and a third direction (DR3) perpendicular to the upper surface of the lower substrate (110), and
the second low voltage lines (124b) and the first high voltage lines (122a) being separated in the second direction (DR2) and the third direction (DR3).

2. The semiconductor memory device of claim 1, wherein the first high voltage lines (122a) each face one of the second high voltage lines (124a) along the third direction (DR3).

3. The semiconductor memory device of claim 1 or 2, wherein the first low voltage lines (122b) each face one of the second low voltage lines (124b) along the third direction (DR3).

4. The semiconductor memory device of any one of claims 1 to 3, wherein a gap (d3) between the first lower lines (122) and the second lower lines (124) is smaller than a gap (d1) between the first lower lines (122) and a gap (d2) between the second lower lines (124).

5. The semiconductor memory device of any one of claims 1 to 4, wherein the first lower lines (122) further include first dummy lines (122c) between the first high voltage lines (122a) and the first low voltage lines (122b).

6. The semiconductor memory device of claim 5, wherein
a first group of the second high voltage lines (124a) face each of the first high voltage lines (122a) along the third direction (DR3), and
a second group of the second high voltage lines (124a) face each of the first dummy lines (122c) along the third direction (DR3).

7. The semiconductor memory device of claim 5 or 6, wherein a first high voltage line and a first low voltage line immediately adj acent to each other among the first high voltage lines (122a) and the first low voltage lines (122b) are separated from each other with at least one of the first dummy lines (122c) interposed therebetween.

8. The semiconductor memory device of any one of claims 1 to 7, wherein the second lower lines (124) further include second dummy lines (124c) between the second high voltage lines (124a) and the second low voltage lines (124b).

9. The semiconductor memory device of claim 8, wherein
a first group of the first low voltage lines (122b) face each of the second low voltage lines (124b) along the third direction (DR3), and
a second group of the first low voltage lines (122b) face each of the second dummy lines (124c) along the third direction (DR3).

10. The semiconductor memory device of claim 8 or 9, wherein a second high voltage line and a second low voltage line immediately adj acent to each other among the second high voltage lines (124a) and the second low voltage lines (124b) are separated from each other with at least one of the second dummy lines (124c) interposed therebetween.

11. The semiconductor memory device of any one of claims 1 to 10, wherein
the peripheral region (100) further includes middle lines (126) electrically connected to the second lower lines (124), and
the middle lines (126) extend along the second direction (DR2) on the second lower lines (124).

12. The semiconductor memory device of claim 11, wherein
the peripheral region (100) further includes upper lines electrically connected to the middle lines (126), and
wherein the upper lines (128) extend along the first direction (DR1) on the middle lines (126).

13. The semiconductor memory device of any one of claims 1 to 12, wherein
each of the high voltage transistors (112a) includes a high voltage source/drain region and a low voltage source/drain region, and
the first high voltage lines (122a) are electrically connected to the high voltage source/drain region of the high voltage transistors (112a).

14. The semiconductor memory device of any one of claims 1 to 13, wherein
the peripheral region (100) further includes low voltage transistors (112b) on the lower substrate (110), and
the high voltage transistors (112a) and the low voltage transistors (112b) are separated from each other along the first direction (DR1).

15. The semiconductor memory device of any one of claims 1 to 14, wherein the first high voltage lines (122a), the second high voltage lines (124a), the first low voltage lines (122b), or the second low voltage lines (124b) are arranged to be immediately adjacent to each other along the second direction (DR2).
